# EUROPÄISCHE PATENTANMELDUNG

(11) **EP 3 553 679 A1**
(43) Veröffentlichungstag der Anmeldung: **16.10.2019**
(21) Anmeldenummer: 18166972.2
(22) Anmeldetag: 12.04.2018
(51) Int. Cl.: G06F 17/50

(54) **VERFAHREN ZUR COMPUTERGESTÜTZTEN FEHLERDIAGNOSE FÜR EIN TECHNISCHES SYSTEM**

(71) Anmelder: Siemens Aktiengesellschaft, 80333 München (DE)
(72) Erfinder: Fischer, Jan, 81541 München (DE); Wincheringer, Christoph, 81369 München (DE); Baudisch, Thomas, 86938 Schondorf am Ammersee (DE); Roux, Armin, 91052 Erlangen (DE)

(57) **Zusammenfassung**

Die Erfindung betrifft ein Verfahren und eine Vorrichtung zur computergestützten Fehlerdiagnose für ein technisches System. Es wird ein Simulationsmodell (M100) des technischen Systems (100) und ein Steuermodulduplikat (S2) eines Steuermoduls (S1) des technischen Systems (100) bereitgestellt. Es wird ein Ist-Zustand des technischen Systems (100) durch das Steuermodul (S1) und ein Ist-Zustand des Simulationsmodells (M100) durch das Steuermodulduplikat (S2) erfasst. In Folge einer Detektion eines Fehlers des technischen Systems, wird der Ist-Zustand des Simulationsmodells (M100) an den Ist-Zustand des technischen Systems (100), durch Verändern der Einstellwerte von Eingangsparametern des Simulationsmodells (M100) angepasst. Es wird eine Ausgabe des Steuermoduls (S1) und eine Ausgabe des Steuermodulduplikats (S2) geprüft und abhängig vom Prüfergebnis werden die Einstellwerte der Eingangsparameter bereitgestellt. Es können anhand der Einstellwerte Fehlerursachen ermittelt werden.

## Beschreibung

Die Erfindung betrifft ein Verfahren und eine Vorrichtung zur computergestützten Fehlerdiagnose für ein technisches System.

Beim Betrieb von technischen Systemen, wie z.B. Werkzeugmaschinen oder Feldgeräten, kann es zu einem fehlerhaften Betrieb oder zu System- oder Maschinenausfällen durch Fehler in oder am technischen System kommen. Häufig ist die Ermittlung der Fehlerursache nicht praktikabel und zeitnah möglich. Wird die Fehlerursache nicht ermittelt und behoben, kann es zu Stillstandzeiten kommen.

Es ist bekannt, Kataloge, die mögliche Fehlerursachen zusammen mit beobachtbaren Fehlerphänomenen umfassen, für die Fehlerdiagnose zu nutzen. Allerdings ist es oft nicht praktikabel alle möglichen Fehlerursachen zu ermitteln und aufzulisten. Des Weiteren ist bekannt, für die Fehlersuche das fehlerhafte System oder ein baugleiches Modell, d.h. insbesondere einen Hardware-Nachbau, nach Fehlern und Ursachen zu untersuchen. Auch hier können Fehlerursachen meist nicht immer vollständig ermittelt werden. Außerdem kann die Untersuchung des Systems oft Expertenwissen voraussetzen und ist nicht oder nur schwer aus der Ferne möglich.

Es ist eine Aufgabe der Erfindung die Ermittlung von Fehlerursachen von auftretenden Fehlern in einem technischen System zu verbessern.

Die Aufgabe wird gelöst durch ein Verfahren mit den Merkmalen des Patentanspruchs 1, durch eine Vorrichtung mit den Merkmalen des Patentanspruchs 8, durch ein Computerprogrammprodukt mit den Merkmalen des Patentanspruchs 11 sowie durch ein computerlesbares Speichermedium mit den Merkmalen des Patentanspruchs 12. Vorteilhafte Ausführungsformen und Weiterbildungen der Erfindung sind in den abhängigen Ansprüchen angegeben.

Ein erster Aspekt der Erfindung betrifft ein Verfahren zur computergestützten Fehlerdiagnose für ein technisches System, mit folgenden Verfahrensschritten:
- Bereitstellen eines Simulationsmodells des technischen Systems und eines Steuermodulduplikats eines Steuermoduls des technischen Systems,
- Erfassen eines Ist-Zustands des technischen Systems durch das Steuermodul des technischen Systems,
- Erfassen eines Ist-Zustands des Simulationsmodells durch das Steuermodulduplikat,
- Anpassen des Ist-Zustands des Simulationsmodells an den Ist-Zustand des technischen Systems, in Folge einer Detektion eines Fehlers des technischen Systems durch das Steuermodul, durch Verändern der Einstellwerte von Eingangsparametern des Simulationsmodells,
- Prüfen einer Ausgabe des Steuermoduls und einer Ausgabe des Steuermodulduplikats und
- Bereitstellen der veränderten Einstellwerte der Eingangsparameter abhängig vom Prüfergebnis.

Es ist ein Vorteil der Erfindung, ein Simulationsmodell eines technischen Systems zusammen mit einem Steuermodulduplikat zur Fehlerdiagnose zu nutzen. Insbesondere kann ein sogenannter Hardware-in-the-loop-Ansatz für die Fehlerdiagnose genutzt werden, d.h. es kann ein Nachbau oder Duplikat des Steuermoduls, d.h. das Steuermodulduplikat, zusammen mit einem Simulationsmodell des technischen Systems zur Untersuchung des Systems genutzt werden. Insbesondere können mit dem Verfahren nicht oder schwer messbare Fehlerursachen ermittelt werden.

Indem insbesondere ein Ist-Zustand des technischen Systems zu einem vorgegebenen Zeitpunkt mit dem Simulationsmodell durch Verändern der Einstellwerte von Eingangsparametern des Simulationsmodells nachgestellt werden kann, können einzelne oder mehrere Fehlerursachen ermittelt werden. Beispielsweise ist der vorgegebene Zeitpunkt der Zeitpunkt der Detektion eines Fehlers des technischen Systems. Mittels des Steuermoduls kann ein Ist-Zustand des technischen Systems und ggf. zusätzliche ermittelte oder sensorbasierte Angaben erfasst werden.

Es kann mittels des Simulationsmodells z.B. eine dynamische Simulation des Systems durchgeführt werden und ein Ist-Zustand des Simulationsmodells zu dem vorgegebenen Zeitpunkt ermittelt werden. Insbesondere können verschiedene Szenarien simuliert und mit dem realen Zustand des technischen Systems zu diesem Zeitpunkt verglichen werden. Es können mittels des an das Simulationsmodell gekoppelten Steuermodulduplikats Bedienhandlungen durchgeführt und ggf. resultierende Fehler reproduziert werden. Ein Ist-Zustand kann durch das Einstellen der Eingangsparameter des Simulationsmodells, d.h. beispielsweise der Initialwerte der Simulation, angepasst werden.

"Anpassung" kann bedeuten, dass die Einstellwerte von Parametern des Simulationsmodells derart iterativ verändert werden, bis das Simulationsmodell ein tatsächliches physikalisches Verhalten des technischen Systems reproduziert bzw. eine hohe Anpassungsgüte erreicht wird, indem beispielsweise eine Differenz zwischen dem Ist-Zustand des technischen Systems und dem Ist-Zustand des Simulationsmodells minimiert wird. Die Anpassungsgüte kann beispielsweise mittels statistischer Tests bestimmt werden. In anderen Worten, das Simulationsmodell wird derart angepasst, dass sein Ist-Zustand sich dem Ist-Zustand des realen technischen Systems annähert.

Die Ausgabe des Steuermoduls kann mindestens einen Teil des Ist-Zustands des technischen Systems ausgeben, nachdem ein Fehler detektiert wird, beispielsweise in Form einer oder mehrerer Warnmeldungen. Die Ausgabe des Steuermodulduplikats kann entsprechend mindestens einen Teil des Ist-Zustands des Simulationsmodells ausgeben. Die Ausgaben können daraufhin geprüft bzw. miteinander verglichen werden, ob sie sich beispielsweise entsprechen bzw. ein Unterschied zwischen den beiden Ausgaben kleiner als ein vorgegebener Prüfwert ist. Die Einstellwerte der Eingangsparameter des Simulationsmodells können iterativ verändert werden, bis die Ausgaben einer Prüfvorschrift genügen, also beispielsweise eine Differenz der Ausgaben kleiner als ein Prüfwert ist.

Es ist ein Ziel der Anpassung des Simulationsmodells, dass die Ausgabe des Steuermodulduplikats die Ausgabe des Steuermoduls reproduziert. Wenn die beiden Ausgaben eine Prüfvorschrift erfüllen, können die Einstellwerte der Eingangsparameter des Simulationsmodells bereitgestellt werden. Die Einstellwerte der Eingangsparameter können die Fehlerursache angeben bzw. ermöglichen Rückschlüsse auf die Fehlerursache.

Es kann insbesondere das technische System mittels des Steuermodulduplikats gesteuert werden, ohne einen physischen Nachbau des technischen Systems zur Fehlerfindung einzusetzen. Die Erfindung ist vorteilhaft, da beispielsweise die Fehlerdiagnose auch aus der Ferne und/oder mit reduzierten Kosten und/oder mit reduzierten Stillstandzeiten durchgeführt werden kann. Es können insbesondere eine oder mehrere Fehlerursachen bestimmt werden. Beispielsweise können mehrere Fehlerursachen zusammen mit jeweils einem Wahrscheinlichkeitswert ausgegeben werden.

Das Simulationsmodell des technischen Systems, auch als ein digitales Abbild oder digitaler Zwilling des technischen Systems bezeichnet, kann die physikalisch-technischen Eigenschaften des technischen Systems im Simulationsmodell abbilden.

Das Steuermodul überträgt Steuerbefehle an das technische System, wie z.B. an eine Werkzeugmaschine. Das Steuermodul kann insbesondere ein Bedienmodul, wie z.B. eine Benutzerdateneingabe, umfassen. Das Steuermodul kann Steuerbefehle an das technische System übermitteln und beispielsweise Fehlermeldungen vom technischen System empfangen und auswerten. Das Steuermodulduplikat kann insbesondere ein baugleicher Nachbau mit identischen Komponenten oder auch identisch mit dem Steuermodul sein. Das Steuermodul und das Steuermodulduplikat können Steuerbefehle und Fehlermeldungen ausgeben.

In einer vorteilhaften Ausführungsform des Verfahrens kann mittels eines Fehlergenerators mindestens eine Fehlerursache erzeugt werden und die Einstellwerte der Eingangsparameter des Simulationsmodells können gemäß der Fehlerursache eingestellt werden.

Insbesondere können mittels des Fehlergenerators verschiedene Fehlerursachen oder Kombinationen aus Fehlerursachen in die Simulation eingespeist werden. Eine Fehlerursache kann beispielsweise ein Verschleißgrad sein. Die Einstellwerte können mindestens einer Fehlerursache zugeordnet sein. Der Fehlergenerator kann insbesondere auch verschiedene Fehlerursachen kombinieren, wie z.B. einen Verschleißgrad mit einem externen Ereignis. Abhängig von der erzeugten Fehlerursache können die Einstellwerte der Eingangsparameter des Simulationsmodells derart eingestellt werden, dass das Steuermodulduplikat einen Fehler entsprechend der Fehlerursache ausgibt. In anderen Worten, die Einstellwerte werden gemäß der vom Fehlergenerator erzeugten Fehlerursache eingestellt, um ausgehend von der Fehlerursache das System zu simulieren. Die Fehlerursache kann im Simulationsmodell mittels der Einstellwerte der Eingangsparameter reproduziert, d.h. eingestellt, werden. Es kann eine Simulation des Systems ausgehend von dieser Fehlerursache durchgeführt werden und die Ausgabe des Steuermodulduplikats analysiert werden.

In einer weiteren vorteilhaften Ausführungsform des Verfahrens kann ein zeitlicher Verlauf des Ist-Zustands des Simulationsmodells an einen zeitlichen Verlauf des Ist-Zustands des technischen Systems durch Verändern des Simulationsmodells oder der Einstellwerte der Eingangsparameter angepasst werden.

Es kann insbesondere bei der Anpassung des Simulationsmodells an das reale technische System ein zeitlicher Verlauf eines Ist-Zustands angenähert werden. Dazu kann ein zeitlicher Verlauf eines Ist-Zustands, wie z.B. während einer Betriebsphase, des technischen Systems ermittelt und eine dynamische Simulation das Simulationsmodell derart angepasst werden, dass der zeitlicher Verlauf des Ist-Zustands des Simulationsmodells den des technischen Systems annähert. Es können damit insbesondere komplexere Fehlerursachen mit mehrstufigen Ursache-Wirkungs-Beziehungen ermittelt werden.

In einer weiteren vorteilhaften Ausführungsform des Verfahrens kann das Simulationsmodell eindimensional oder zweidimensional oder dreidimensional strukturiert oder in einer Kombination daraus bereitgestellt werden.

Abhängig von der Komplexität des technischen Systems und/oder der zu untersuchenden Betriebsabläufe des technischen Systems kann die Raumdimension für das Simulationsmodell gewählt werden. Es kann ein Simulationsmodell mehrere Modellteile umfassen, welche in verschiedenen Raumdimensionen modelliert sein können. Beispielsweise kann eine Kombination aus einem eindimensionalen Modell und einem zweidimensionalen Modell bereitgestellt werden.

In einer weiteren vorteilhaften Ausführungsform des Verfahrens kann der Ist-Zustand des Simulationsmodells an den Ist-Zustand des technischen Systems abhängig von vorab ermittelten Fehlerursachen und/oder statistischen Zusammenhängen von Fehlerursachen angepasst werden.

Es können beispielsweise Fehlerursachen von vorhergehenden Analysen von fehlerhaften Zuständen des gleichen technischen Systems und/oder eines baugleichen Systems bekannt sein. Daraus ermittelte Merkmale von Fehlerursachen können für die Fehlerdiagnose genutzt werden. Dies kann insbesondere tiefere Kenntnisse über Zusammenhänge von Fehlerursachen liefern.

In einer weiteren vorteilhaften Ausführungsform des Verfahrens kann eine Software und/oder ein Betriebssystem des Steuermodulduplikats aktualisiert oder an geänderte Betriebsbedingungen angepasst werden.

Eine flexible Aktualisierung und/oder Anpassung des Steuermodulduplikats an geänderte Bedingungen kann beispielsweise eine Fehlerdiagnose von anderen, ggf. baugleichen technischen Systemen ermöglichen.

In einer weiteren vorteilhaften Ausführungsform des Verfahrens können die Einstellwerte der Eingangsparameter und/oder der Fehler des technischen Systems in einer Datenbank gespeichert werden.

Es können ermittelte Fehlerursachen für den detektierten Fehler des technischen Systems in einer Datenbank hinterlegt werden und für zukünftige Fehlerdiagnosen des gleichen oder eines ähnlichen Systems genutzt werden, um die Fehlersuche zu beschleunigen oder zu verbessern oder bestimmte Fehlerursachen zu vermeiden. Es können beispielsweise auch Fehler, d.h. Auswirkungen bestimmter Fehlerursachen, und insbesondere eine Zuordnung zueinander gespeichert werden.

Ein weiterer Aspekt der Erfindung betrifft eine Vorrichtung zur computergestützten Fehlerdiagnose für ein technisches System, umfassend:
- ein Simulationsmodell des technischen Systems,
- ein Steuermodulduplikat eines Steuermoduls des technischen Systems zum Erfassen des Ist-Zustands des Simulationsmodells durch das Steuermodulduplikat,
- ein Anpassungsmodul zum Anpassen des Ist-Zustands des Simulationsmodells an den Ist-Zustand des technischen Systems, in Folge einer Detektion eines Fehlers des technischen Systems durch das Steuermodul, durch Verändern der Einstellwerte von Eingangsparametern des Simulationsmodells,
- Prüfmodul zum Prüfen der Ausgabe des Steuermoduls und der Ausgabe des Steuermodulduplikats,
   und
- ein Bereitstellungsmodul zum Bereitstellen der veränderten Einstellwerte der Eingangsparameter abhängig vom Prüfergebnis.

Ein Anpassungsmodul kann insbesondere als ein Löser, auch als Solver bezeichnet, realisiert sein. Das Prüfmodul kann mittels einer Prüfvorschrift die Ausgabe des Steuermoduls und des Steuermodulduplikats prüfen, beispielsweise miteinander vergleichen. Abhängig vom Prüfergebnis, z.B. wenn eine Abweichung der Ausgabe des Steuermoduls von der Ausgabe des Steuermodulduplikats geringer ist als ein vorgegebener Schwellwert, können die Einstellwerte der Eingangsparameter bereitgestellt werden und daraus die Fehlerursachen ermittelt werden.

In einer vorteilhaften Ausführungsform kann die Vorrichtung einen Fehlergenerator umfassen, der derart eingerichtet ist, mindestens eine Fehlerursache zu erzeugen und die Einstellwerte der Eingangsparameter des Simulationsmodells gemäß der Fehlerursache einzustellen.

Insbesondere kann der Fehlergenerator zufällige Fehlerursachen generieren und beispielsweise miteinander kombinieren. Es können entsprechend der Fehlerursachen die Einstellwerte der Eingangsparameter beliebig verändert werden.

In einer vorteilhaften Ausführungsform kann die Vorrichtung eine Datenbank umfassen, die derart eingerichtet ist, die Einstellwerte der Eingangsparamater und/oder der Fehler des technischen Systems zu speichern.

Des Weiteren betrifft die Erfindung ein Computerprogrammprodukt, das direkt in einen programmierbaren Computer ladbar ist, umfassend Programmcodeteile, die dazu geeignet sind, die Schritte des Verfahrens durchzuführen und ein computerlesbares Speichermedium.

Ausführungsbeispiele des erfindungsgemäßen Verfahrens und der Vorrichtung sind in den Zeichnungen beispielhaft dargestellt und werden anhand der nachfolgenden Beschreibung näher erläutert. Es zeigen in schematischer Darstellung:
- Fig. 1: ein Ablaufdiagramm des erfindungsgemäßen Verfahrens zur computergestützten Fehlerdiagnose für ein technisches System;
- Fig. 2: eine Veranschaulichung des erfindungsgemäßen Verfahrens zur computergestützten Fehlerdiagnose für ein technisches System;
und
- Fig. 3: ein Blockdiagramm der erfindungsgemäßen Vorrichtung zur computergestützten Fehlerdiagnose für ein technisches System.

Einander entsprechende Gegenstände sind in allen Figuren mit den gleichen Bezugszeichen versehen.

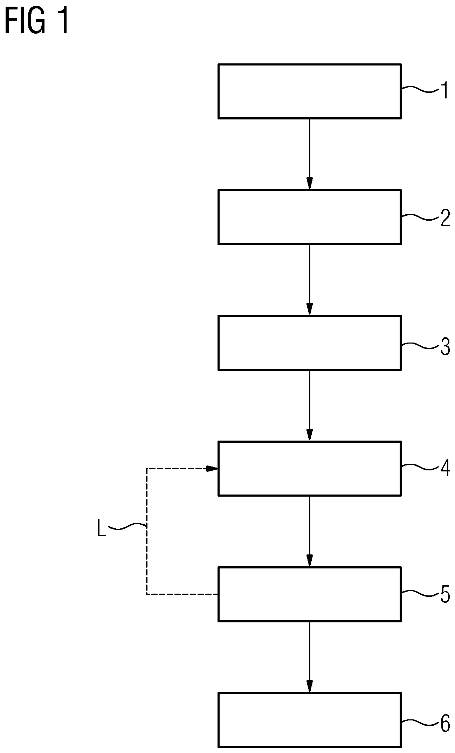

Figur 1 zeigt als Ablaufdiagramm ein Ausführungsbeispiel des erfindungsgemäßen Verfahrens zur computergestützten Fehlerdiagnose für ein technisches System. Im ersten Schritt 1 des erfindungsgemäßen Verfahrens wird ein Simulationsmodell M100 des technischen Systems 100 bereitgestellt. Insbesondere beschreibt das Simulationsmodell M100 technische Eigenschaften des Systems und erlaubt die Durchführung einer Simulation einer zeitlichen Entwicklung des Systems 100. Zusätzlich wird in Schritt 1 ein Steuermodulduplikat S2 eines Steuermoduls S1 des technischen Systems bereitgestellt, womit das Simulationsmodell M100 gesteuert werden kann.

Im Schritt 2 wird ein Ist-Zustand des technischen Systems zu einem vorgegebenen Zeitpunkt erfasst. Beispielsweise kann der Ist-Zustand des technischen Systems mittels Sensoren erfasst werden und an die Ausgabe des Steuermoduls S1 übergeben werden.

Im Schritt 3 des Verfahrens wird ein Ist-Zustand des Simulationsmodells M100 erfasst. Dazu wird das Simulationsmodell M100 ausgewertet, d.h. es wird eine Simulation des technischen Systems 100 durchgeführt.

Im Schritt 4 wird der Ist-Zustand des Simulationsmodells M100 an den Ist-Zustand des technischen Systems 100 beispielsweise über einen Fitting-Prozess angepasst, nachdem das Steuermodul einen Fehler gemeldet hat. Dazu werden Einstellwerte von Eingangsparametern des Simulationsmodells M100 iterativ verändert, das Simulationsmodell M100 wird, z.B. über einen vorgegebenen Zeitraum, ausgewertet und ein Ist-Zustand des Simulationsmodells wird mittels des Steuermodulduplikats S2 ermittelt.

Im Schritt 5 des Verfahrens werden die Ausgabe des Steuermoduls und die Ausgabe des Steuermodulduplikats geprüft, wie z.B. miteinander verglichen. Der Ist-Zustand des technischen Systems 100 wird unter anderem mittels der Ausgabe des Steuermoduls S1 angezeigt. Beispielsweise kann eine Fehlermeldung vorliegen. Der Ist-Zustand des Simulationsmodells M100 wird vom Steuermodulduplikat S2 erfasst. Es wird geprüft, ob die Ausgaben eine Prüfvorschrift erfüllen.
Insbesondere können die Einstellwerte der Eingangsparameter des Simulationsmodells M100 so lange, z.B. iterativ, verändert werden bis die Ausgaben des Steuermoduls und des Steuermodulduplikats die Prüfvorschrift erfüllen, siehe Pfeil L. Die Prüfvorschrift kann beispielsweise angeben, dass eine Differenz der Ausgaben einen vorgegebenen Schwellwert unterschreiten muss.

Im Schritt 6 werden die veränderten Einstellwerte der Eingangsparameter des Simulationsmodells M100 ausgegeben, wenn die Prüfvorschrift erfüllt ist. Anhand der ermittelten Einstellwerte der Eingangsparameter können Fehlerursachen abgeleitet werden.

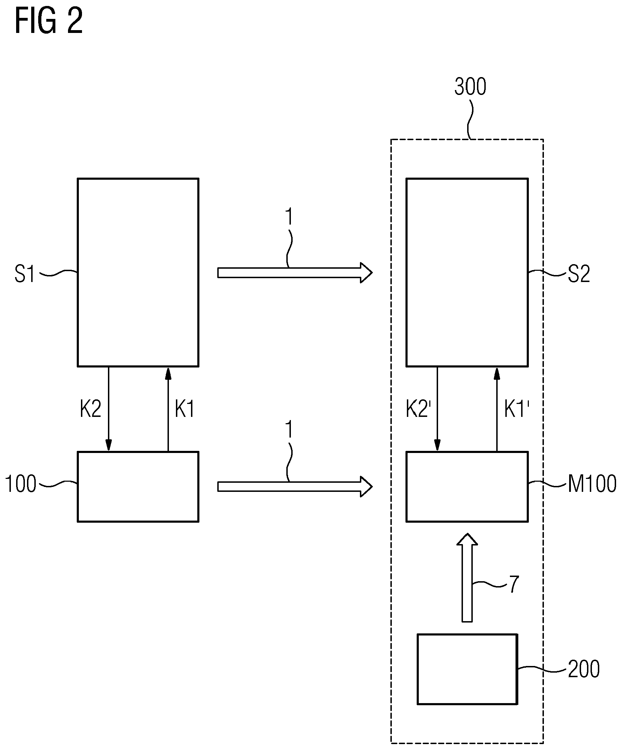

Figur 2 zeigt schematisch eine Veranschaulichung des erfindungsgemäßen Verfahrens zur computergestützten Fehlerdiagnose für ein technisches System.

Ein technisches System 100 kann eine Maschine oder Werkzeugmaschine, ein Fahrzeug, ein Feldgerät, eine Automatisierungsanlage oder ein Kraftwerk sein, welches mittels eines Steuermoduls S1 gesteuert wird. Insbesondere kann das Steuermodul S1 ein Betriebsmodul, wie z.B. ein Eingabefeld oder ein Bedientablett oder eine Mensch-Maschinen-Schnittstelle, umfassen. Das Steuermodul S1 übermittelt dem technischen System 100 Steuerbefehle als Ausgangssignale über den Steuerkanal K2. Das technische System 100 übermittelt dem Steuermodul S1 Eingangssignale über den Kanal K1. Beispielsweise können Eingangssignale Fehlermeldungen umfassen, worauf das Steuermodul abhängig vom Ist-Zustand des technischen Systems z.B. Alarmsignale oder Zustandsmeldungen ausgibt oder anzeigt.

Es wird ein Simulationsmodell M100 des technischen Systems mittels eines Modellierungsverfahrens bereitgestellt, siehe Schritt 1 in Figur 1. Je nach Komplexität des technischen Systems 100, kann das Simulationsmodell M100 eindimensional oder zweidimensional oder dreidimensional strukturiert bereitgestellt werden. Es können auch verschiedene Modelle von verschiedenen Komponenten des technischen Systems 100 im Simulationsmodell M100 in unterschiedlichen Raumdimensionen modelliert sein.

Es wird ein Steuermodulduplikat S2, insbesondere ein Hardware-Nachbau des Steuermoduls S1, bereitgestellt, siehe Schritt 1 in Figur 1. Es kann für die Fehlerdiagnose auch dasselbe Steuermodul S1 als Steuermodulduplikat S2 genutzt werden. Das Steuermodulduplikat S2 umfasst die gleichen Komponenten und technischen Eigenschaften wie das Steuermodul S1, insbesondere umfasst es Signalein- und ausgänge zum Steuern eines technischen Systems. Das Steuermodulduplikat S2 kann genutzt werden, das Simulationsmodell M100 zu steuern. Es werden Eingangssignale, wie z.B. Fehlermeldungen, des Simulationsmodells M100 über den Eingangskanal K1' dem Steuermodulduplikat S2 übergeben. Das Steuermodulduplikat S2 kann Steuerbefehle an das Simulationsmodell M100 über den Ausgangskanal K2' übergeben. Die Steuerung des Simulationsmodells M100 erfolgt analog zur Steuerung des technischen Systems 100. Eine Software und/oder ein Betriebssystem des Steuermodulduplikats kann insbesondere aktualisiert oder an geänderte Betriebsbedingungen angepasst werden.

Mittels der erfindungsgemäßen Vorrichtung 300, die insbesondere das Simulationsmodell M100, das Steuermodulduplikat S2 und einen Fehlergenerator 200 umfasst, kann das erfindungsgemäße Verfahren durchgeführt werden. Zur Diagnose eines im technischen System 100 detektierten Fehlers, kann die Vorrichtung 300 den Fehler reproduzieren und die Fehlerursachen daraus ableiten.

Es wird zunächst ein Ist-Zustand des technischen Systems, insbesondere inklusive Fehlermeldung, z.B. Auslösen einer Warnleuchte, durch das Steuermodul S1 erfasst.

Mittels beispielsweise eines Fitting-Prozesses wird das Simulationsmodell M100 an den Ist-Zustand des technischen Systems angepasst. Es wird das Simulationsmodell M100 derart angepasst, dass die Ausgabe des Steuermodulduplikats S2 beispielsweise der Ausgabe des Steuermoduls S1 entspricht oder diese bis zu einem vorgegeben Grad annähert. Beispielsweise wird damit erreicht, dass das Steuermodulduplikat S2 die gleiche Fehler- oder Warnmeldung ausgibt wie das Steuermodul S1.

Insbesondere werden Einstellwerte der Eingangsparameter des Simulationsmodells M100 iterativ verändert, so dass die Ausgabe des Ist-Zustand des Simulationsmodells M100 der Ausgabe des Ist-Zustand des technischen Systems entspricht. Die Einstellwerte werden mittels des Anpassungsmoduls, z.B. eines Solvers, gefunden und von einem Prüfmodul geprüft. Es kann eine iterative Anpassung erfolgen bis eine Prüfvorschrift erfüllt ist. Die Eingangsparameter des Simulationsmodells M100 können nicht oder schwer messbare Parameter des technischen Systems abbilden, wie z.B. einen Verschleißgrad einer Komponente des technischen Systems. Die Fehlersuche kann daher auf der Optimierung der Einstellwerte basieren, indem diese iterativ verändert werden und für jede Iteration der Ist-Zustand des technischen Systems 100 mit dem Ist-Zustand des Simulationsmodells M100 verglichen wird. Es können auf diese Weise auch komplexe Fehlerszenarien überprüft werden, die sich aus einer Kombination mehrerer Einstellwerte oder Einstellwertverläufe der Eingangsparameter ergeben.

Es kann eine Prüfvorschrift vorgegeben werden, mittels der die Ausgaben geprüft werden. Beispielsweise ist die Prüfvorschrift ein Schwellwert, unter den beispielsweise eine Differenz der beiden Ausgaben fallen muss. Die Einstellwerte der Eingangsparameter werden abhängig vom Prüfergebnis ausgegeben. Die Einstellwerte der Eingangsparameter erlauben Rückschluss auf die Fehlerursache bzw. erlauben Fehlerursachen auszuschließen. Die Einstellwerte können beispielsweise einer oder mehrerer Fehlerursachen zugeordnet sein, wobei eine Fehlerursache mittels eines Fehlergenerators 200 generiert wird.

Insbesondere kann ein Fehlergenerator 200 eine Fehlerursache, z.B. eine Beschädigung oder eine Störung oder eine Kombination daraus, des technischen Systems generieren und daraus Einstellwerte für das Simulationsmodell ermitteln. Die Ausgabe des Fehlergenerators 200 wird dem Simulationsmodell M100 in Form von Einstellwerten der Eingangsparameter des Simulationsmodells M100 übergeben. Die Einstellwerte der Eingangsparameter des Simulationsmodells M100 werden abhängig von den generierten Fehlerursachen eingestellt, siehe Pfeil 7.

Das Steuermodul S1 kann den zeitlichen Verlauf des Ist-Zustands des technischen Systems 100 erfassen. Beispielsweise kann ein Fehlerverlauf durch den zeitlichen Verlauf einer Messgröße ermittelt werden. Der Fehler kann beispielsweise auch durch eine Alarmmeldung auf dem Steuermodul S1 angezeigt werden. Ausgehend von dieser Alarmmeldung und bekannten Parametern des technischen Systems 100 kann mittels einer dynamischen Simulation und durch Anpassen der Einstellwerte der Eingangsparameter ein zeitlicher Verlauf eines Ist-Zustands des Simulationsmodells M100 angepasst werden, um gemäß der Erfindung die Fehlerursache zu ermitteln.

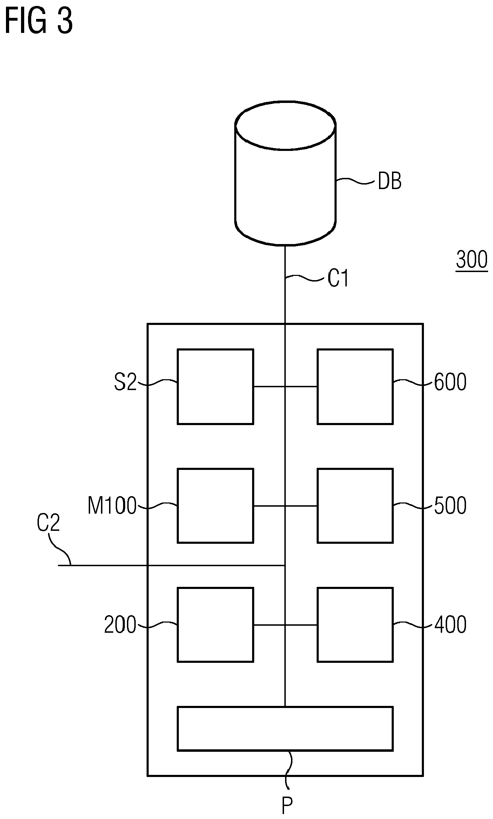

Figur 3 zeigt ein Ausführungsbeispiel der erfindungsgemäßen Vorrichtung 300 zur Fehlerdiagnose für ein technisches System 100. Die Vorrichtung 300 kann eine Datenbank DB umfassen, wobei diese über eine erste Kommunikationsverbindung C1 verbunden sein können.

Die Vorrichtung 300 umfasst des Weiteren ein Simulationsmodell M100 des technischen Systems 100, ein Steuermodulduplikat S2, welches das Simulationsmodell M100 steuert, ein Anpassungsmodul 400, ein Prüfmodul 500, ein Bereitstellungsmodul 600, einen Fehlergenerator 200 und einen Prozessor P. Die Vorrichtung 300 kann eine zweite Kommunikationsverbindung C2 aufweisen, welche beispielsweise eine Kommunikation mit dem technischen System 100 ermöglicht. Beispielsweise kann über die zweite Kommunikationsverbindung C2 der Ist-Zustand des technischen Systems 100 an die Vorrichtung 300 übermittelt werden. Das Anpassungsmodul 400, wie z.B. ein genetischer Algorithmus, kann das Simulationsmodell M100 oder die Einstellwerte der Eingangsparameter des Simulationsmodells M100 derart anpassen, dass ein Ist-Zustand des Simulationsmodells M100 einen Ist-Zustand des technischen Systems 100 reproduziert, nachdem ein Fehler des technischen Systems detektiert wurde. Dazu werden beispielsweise vom Fehlergenerator 200 verschiedene Fehlerursachen generiert und vom Fehlergenerator 200 daraus die Einstellwerte der Eingangsparameter des Simulationsmodells eingestellt. Das Anpassungsmodul 400 und/oder das Prüfmodul 500 können auch als Teil des Fehlergenerators 200 verstanden werden.

Es kann auch ein Fehler ausgehend von den Einstellwerten der Eingangsparameter, abhängig von der vom Fehlergenerator 200 erzeugten Fehlerursache, simuliert werden. Anhand des Vergleichs der Ausgaben des Steuermoduls und des Steuermodulduplikats kann ermittelt werden, ob die erzeugte Fehlerursache den detektierten Fehler erklären kann.

Die Ausgabe des Steuermoduls S1 erfasst den Ist-Zustand des technischen Systems 100 und das Steuermodulduplikat S2 erfasst den Ist-Zustand des Simulationsmodells M100. Das Prüfmodul 500 ist derart eingerichtet, anhand einer Prüfvorschrift zu prüfen, ob die Ausgaben diese Prüfvorschrift erfüllen.

Beispielsweise kann die Prüfvorschrift einen Schwellwert umfassen, unter den eine Differenz der beiden Ausgaben fallen muss. Ist die Prüfvorschrift nicht erfüllt, kann das Prüfmodul 500 dem Anpassungsmodul 400 eine Rückmeldung geben und die Einstellwerte der Eingangsparameter werden weiter verändert bis die Prüfvorschrift erfüllt ist. Die Prüfvorschrift kann des Weiteren auch eine Bedingung umfassen, dass die Ausgaben zusammen mit z.B. einem Differenzwert ausgegeben werden. Damit kann beispielsweise eine statistische Auswertung der Fehlerursachen durchgeführt werden und/oder Fehlerursachen eingegrenzt oder ausgeschlossen werden.

Ermittelt das Prüfmodul 500, dass die Ausgaben der Prüfvorschrift genügen, stellt das Bereitstellungsmodul 600 die finalen Einstellwerte der Eingangsparameter bereit.

Die Einstellwerte der Eingangsparameter und/oder daraus ermittelte Fehlerursachen können über die erste Kommunikationsverbindung C1 an die Datenbank DB übertragen und dort gespeichert werden. Es können auch die detektierten Fehler aus den erfassten Ist-Zuständen des technischen Systems in der Datenbank DB gespeichert werden. Die Speicherung in der Datenbank DB ermöglicht, bei einer erneuten Analyse eines Fehlers des technischen Systems, eine Sammlung an bereits bekannten Fehlern und Fehlerzusammenhängen zu nutzen. Es können aus den ermittelten Fehlern und deren Ursachen auch statistische Zusammenhänge von verschiedenen Fehlerursachen abgeleitet werden. Die Fehlerursachen und/oder statistischen Zusammenhänge, d.h. beispielsweise auch bekannte Informationen und Vorkenntnisse über das technische System 100 und dessen Komponenten, können insbesondere dem Anpassungsmodul 400 und/oder dem Fehlergenerator 200 bereitgestellt werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Verfahren zur computergestützten Fehlerdiagnose für ein technisches System, mit folgenden Verfahrensschritten:
- Bereitstellen (1) eines Simulationsmodells (M100) des technischen Systems (100) und eines Steuermodulduplikats (S2) eines Steuermoduls (S1) des technischen Systems (100),
- Erfassen (2) eines Ist-Zustands des technischen Systems (100) durch das Steuermodul (S1) des technischen Systems,
- Erfassen (3) eines Ist-Zustands des Simulationsmodells (M100) durch das Steuermodulduplikat (S2),
- Anpassen (4) des Ist-Zustands des Simulationsmodells (M100) an den Ist-Zustand des technischen Systems (100), in Folge einer Detektion eines Fehlers des technischen Systems durch das Steuermodul (S1), durch Verändern der Einstellwerte von Eingangsparametern des Simulationsmodells (M100),
- Prüfen (5) einer Ausgabe des Steuermoduls (S1) und einer Ausgabe des Steuermodulduplikats (S2)
und
- Bereitstellen (6) der veränderten Einstellwerte der Eingangsparameter abhängig vom Prüfergebnis.

2. Verfahren nach Anspruch 1, wobei mittels eines Fehlergenerators (200) mindestens eine Fehlerursache erzeugt wird und die Einstellwerte der Eingangsparameter des Simulationsmodells gemäß der Fehlerursache eingestellt werden.

3. Verfahren nach einem der vorhergehenden Ansprüche, wobei ein zeitlicher Verlauf des Ist-Zustands des Simulationsmodells (M100) an einen zeitlichen Verlauf des Ist-Zustands des technischen Systems (100) durch Verändern des Simulationsmodells (M100) oder der Einstellwerte der Eingangsparameter angepasst wird.

4. Verfahren nach einem der vorhergehenden Ansprüche, wobei das Simulationsmodell (M100) eindimensional oder zweidimensional oder dreidimensional strukturiert oder in einer Kombination daraus bereitgestellt wird.

5. Verfahren nach einem der vorhergehenden Ansprüche, wobei der Ist-Zustand des Simulationsmodells (M100) an den Ist-Zustand des technischen Systems (100) abhängig von vorab ermittelten Fehlerursachen und/oder statistischen Zusammenhängen von Fehlerursachen angepasst wird.

6. Verfahren nach einem der vorhergehenden Ansprüche, wobei eine Software und/oder ein Betriebssystem des Steuermodulduplikats (S2) aktualisiert oder an geänderte Betriebsbedingungen angepasst wird.

7. Verfahren nach einem der vorhergehenden Ansprüche, wobei die Einstellwerte der Eingangsparameter und/oder der Fehler des technischen Systems (100) in einer Datenbank (DB) gespeichert wird.

8. Vorrichtung zur computergestützten Fehlerdiagnose für ein technisches System, umfassend:
- ein Simulationsmodell (M100) des technischen Systems,
- ein Steuermodulduplikat (S2) eines Steuermoduls (S1) des technischen Systems (100) zum Erfassen des Ist-Zustands des Simulationsmodells (M100) durch das Steuermodulduplikat (S2),
- ein Anpassungsmodul (400) zum Anpassen des Ist-Zustands des Simulationsmodells (M100) an den Ist-Zustand des technischen Systems (100), in Folge einer Detektion eines Fehlers des technischen Systems (100) durch das Steuermodul (S1), durch Verändern der Einstellwerte von Eingangsparametern des Simulationsmodells (M100),
- Prüfmodul (500) zum Prüfen der Ausgabe des Steuermoduls (S1) und der Ausgabe des Steuermodulduplikats (S2),
und
- ein Bereitstellungsmodul (600) zum Bereitstellen der veränderten Einstellwerte der Eingangsparameter abhängig vom Prüfergebnis.

9. Vorrichtung (300) nach Anspruch 8, umfassend einen Fehlergenerator (200), der derart eingerichtet ist, mindestens eine Fehlerursache zu erzeugen und die Einstellwerte der Eingangsparameter des Simulationsmodells (M100) gemäß der Fehlerursache einzustellen.

10. Vorrichtung (300) nach Anspruch 8 oder 9 umfassend eine Datenbank (DB), die derart eingerichtet ist, die Einstellwerte der Eingangsparameter und/oder Fehler des technischen Systems zu speichern.

11. Computerprogrammprodukt, das direkt in einen programmierbaren Computer ladbar ist, umfassend Programmcodeteile, die dazu geeignet sind, die Schritte des Verfahrens nach einem der Ansprüche 1 bis 7 durchzuführen.

12. Computerlesbares Speichermedium mit einem Computerprogrammprodukt nach Anspruch 11.
